**Europäisches Patentamt**

**European Patent Office**

**Office européen des brevets**

(19)

(11) **EP 1 587 144 A1**

(12) **EUROPEAN PATENT APPLICATION**

(43) Date of publication:
**19.10.2005 Bulletin 2005/42**

(51) Int Cl.7: **H01L 23/544**, G03F 7/20

(21) Application number: **04425268.2**

(22) Date of filing: **13.04.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK**<br><br>(71) Applicant: **STMicroelectronics S.r.l.**<br>**20041 Agrate Brianza (Milano) (IT)**<br><br>(72) Inventors:<br>• **Casella, Giuseppina**<br>**95020 Cannizzaro Catania (IT)** | • **Cina', Giuseppe**<br>**96010 Siricusa (IT)**<br>• **D'Urzo, Vincenzo**<br>**80059 Torre Del Greco Napoli (IT)**<br><br>(74) Representative: **Ferrari, Barbara**<br>**Botti & Ferrari S.r.l.,**<br>**Via Locatelli, 5**<br>**20124 Milano (IT)** |

(54) **Test structure for an electronic device and corresponding test method**

(57)    A testing structure (1) for an electronic device is described, of the type comprising a first and second terminal (T1, T2) effective for providing impedance values of the testing structure (1), as well as an architecture (2) of distributed impedance elements (3-1, 3-2, ..., 3-N) associated with a plurality of configurations of the device to be tested having different criticality levels and connected, in parallel with each other, between the first and second terminal (T1, T2).

A testing method for an electronic device is also described, of the type comprising the steps of:

- providing a testing structure (1) comprising a first and second terminal (T1, T2) connected by means of an architecture (2) of distributed impedance elements;

- providing a plurality of configurations of the device to be tested having a different criticality;

- associating the plurality of configurations of the device to be tested with a plurality of impedance elements (3-1, 3-2, ..., 3-N) of the architecture (2) connected, in parallel with each other, to the first and second terminal (T1, T2);

- subjecting the configurations of the device to be tested to a testing step;

- measuring an impedance value (ZTOT) of the architecture (2) in correspondence with the first and second terminal (T1, T2); and

- calculating a highest criticality level of a configuration of the device to be tested being capable of overcoming the testing step on the basis of the measured impedance value (ZTOT).

FIG. 1

**Description**

Field of application

The present invention relates to an electronic device testing structure.

The invention also relates to an electronic device testing method.

The invention particularly relates, but not exclusively, to an electronic device testing method and structure which can be used during the device manufacturing process to estimate a highest criticality level of the device being capable of overcoming a predetermined testing step and the following description is made with reference to this field of application for convenience of illustration only.

Prior art

As it is well known, in order to monitor particularly critical steps of an electronic device manufacturing process, an impedance testing structure, integrated in the device itself, is provided.

Particularly, in a normal process flow suitable for realising an integrated electronic device, the following steps can be for example critical:

- defining polysilicon and/or metal lines;

- growing self-aligned silicide and/or salicide layers; and

- overlapping two or more critical layers.

The known impedance testing structures provide a response of the on/off type corresponding to the success or failure of the test undergone by the device, i.e. to the right or wrong fulfilment of the monitored step.

They are normally realised by means of contact structures or vias chains. It is also possible to use conveniently located metal strips.

Although advantageous under many aspects, these known solutions have the main drawback of providing only responses of the on/off type to the single testing operations being performed.

The technical problem underlying the present invention is to provide a testing structure for an electronic device, having such structural and functional features as to be capable of overcoming the limits and drawbacks still affecting prior art testing structures.

Summary of the invention

The solution idea underlying the present invention is to provide a testing structure having a distributed architecture associated to a plurality of configurations of a device, capable of providing "multilevel" responses concerning the operation of this device in correspondence with respective contact terminals being provided in the structure itself.

On the basis of this solution idea the technical problem is solved by a testing structure as previously indicated and defined in the characterising part of claim 1.

The problem is also solved by a testing method of an integrated electronic device as previously indicated and defined in the characterising part of claim 10.

The features and advantages of the testing method and structure according to the invention will be apparent from the following description of an embodiment thereof given by way of indicative and non-limiting example with reference to the attached drawings.

Brief description of the drawings

In these drawings:

- Figure 1 shows a testing structure realised according to the invention;

- Figures 2A to 2F show a first application example of the testing structure of figure 1;

- Figure 3 is a diagram concerning the results of experimental tests on the example of figures 2A to 2F; and

- Figures 4A and 4B show a second application example of the testing structure of figure 1.

Detailed description

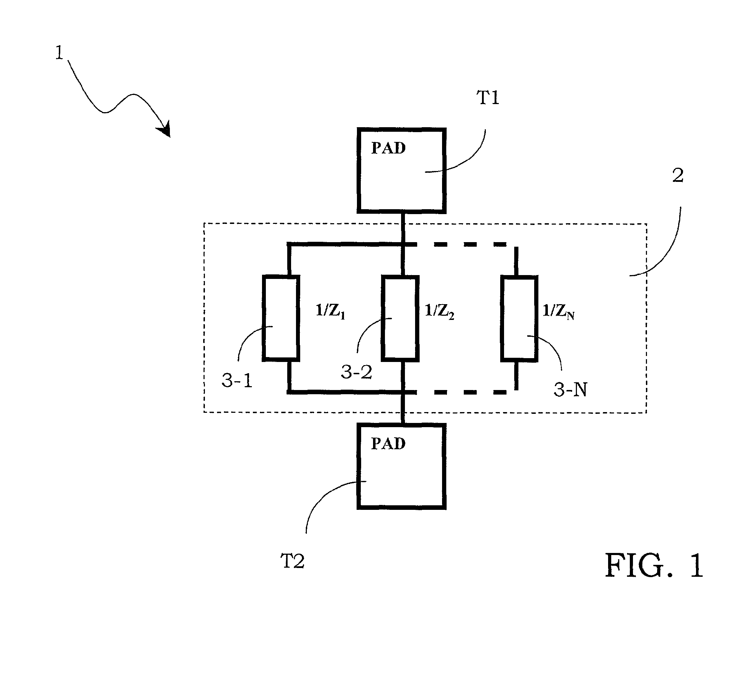

With reference to these drawings, and particularly to figure 1, a testing structure realised according to the present invention is schematically and globally indicated with 1.

The testing structure 1 comprises a first T1 and second terminal T2 connected with each other by means of an architecture 2 of distributed impedance elements.

The architecture 2 comprises a plurality of impedance elements 3-1, 3-2, ..., 3-N having different impedance values 1/Z1, 1/Z2, ..., 1/ZN and connected, in parallel with each other, between the first T1 and second terminal T2.

Advantageously according to the invention, the impedance elements 3-1, 3-2, ..., 3-N of the architecture 2 provide N response levels from the testing structure 1.

Particularly, these impedance elements 3-1. 3-2, ..., 3-N are connected with different configurations of a device to be tested, having different parameters and thus a different criticality.

In a preferred embodiment, the terminals T1 and T2 of the testing structure 1 are realised by means of mini contact pads integrated on board of an electronic device which is to be tested.

Therefore, the testing structure 1 according to the invention integrated in an electronic device realises a multilevel monitoring system which is available to a final user of the device itself.

In its most general aspect, the present invention provides a testing method of an electronic device comprising the steps of:

- providing a testing structure 1 comprising a first T1 and second terminal T2 connected by means of an architecture 2 of distributed impedance elements;

- providing a plurality of configurations of a device to be tested having a different criticality;

- associating this plurality of configurations of the device to be tested with a plurality of impedance elements 3-1, 3-2, ..., 3-N of this architecture 2 connected, in parallel with each other, with the terminals T1 and T2;

- subjecting the different device configurations to a testing step;

- measuring an impedance value ZTOT of the architecture 2; and

- calculating the highest criticality of the device configuration being capable of overcoming this testing step on the basis of the obtained impedance value ZTOT.

In substance, given a device configuration to be monitored, the method according to the invention provides the use of an architecture 2 comprising N impedance elements 3-1. 3-2, ..., 3-N associated with N configurations with different criticality levels.

Particularly, the plurality of critical device configurations are arranged so as to have a growing "weight", the "weight" index being determined by the associated impedance. By way of example, considering N configurations, connected in correspondence with the ends thereof to the terminals T1 and T2, having associated impedances Z1, Z2, ..., ZN, the following relation is set:

$$|Z1| < |Z2| < ... < |ZN| \qquad (1)$$

ZN being the less critical impedance.

Given the parallel structure of the architecture 2, the total impedance value ZTOT thereof thus satisfies the relation:

$$1/ZTOT = 1/Z1 + 1/Z2 + ... 1/ZN \qquad (2)$$

If M configurations, starting from the most critical, do not overcome the testing step (the M-th configuration being the less critical among the ones not passing the test), the total impedance ZTOT thus satisfies the relation;

$$1/ZTOT = 1/ZM + 1 + ... 1/ZN \qquad (3)$$

In other words, the value of the total impedance ZTOT of the architecture 2 provides an indication of the highest criticality that the device configuration can "withstand" in the range of critical configuration being analysed.

For a better understanding of the testing structure 1 and of the method according to the invention two embodiments will now be described, which must be considered by way of illustrative and non-limiting examples of the invention.

Considering a SRAM memory manufacturing process, the criticality of the LIL ("Local Interconnection Level") mask overlapping with respect to the poly mask is known in the specific technical field.

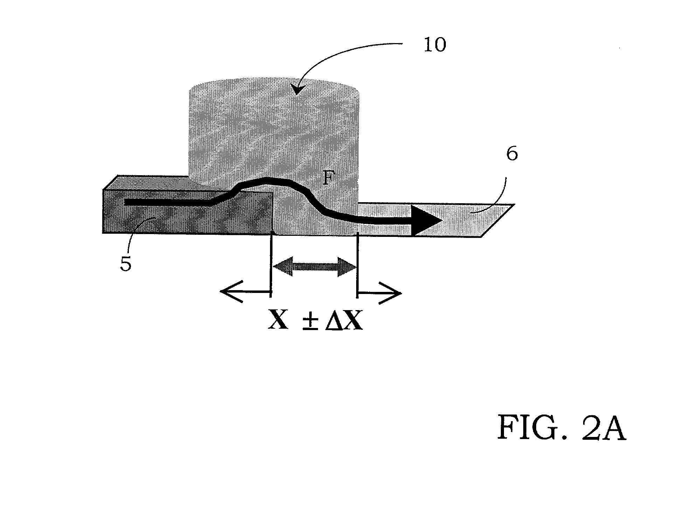

Referring to the figures 2A to 2F, a testing structure 1 comprising three parallel resistors is shown, which is effective for monitoring the misalignment between a LIL mask and a poly mask in a SRAM memory manufacturing process.

In this case, the device configuration, whose criticality must be estimated, comprises these masks and the change of the distance between them.

Figure 2A shows an impedance element 10 associated with a first mask 5 and with a second mask 6 being located at a distance X, being variable by $\pm\Delta X$.

Advantageously according to the invention, the impedance element 10 comprises a resistance being configured in such a way to contact the first 5 and second mask 6. The arrow F indicates the current flow in the impedance element 10.

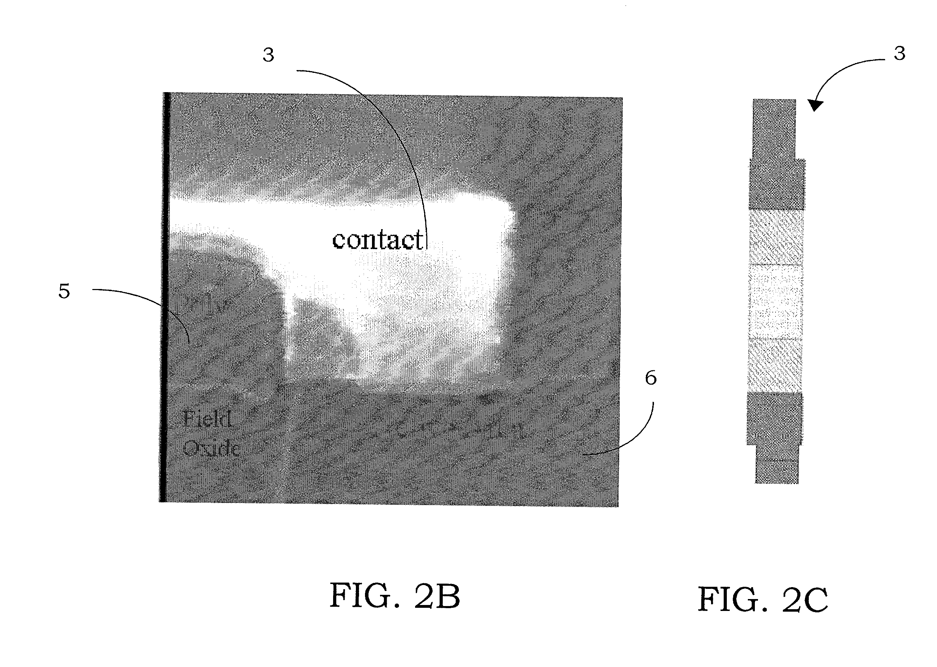

In the specific case being shown, the first mask 5 is the poly mask, while the second mask 6 is the LIL mask, as shown in figures 2B and 2C showing a SEM section of a device comprising the testing structure 1 in correspondence with this resistance 3 and the corresponding layout.

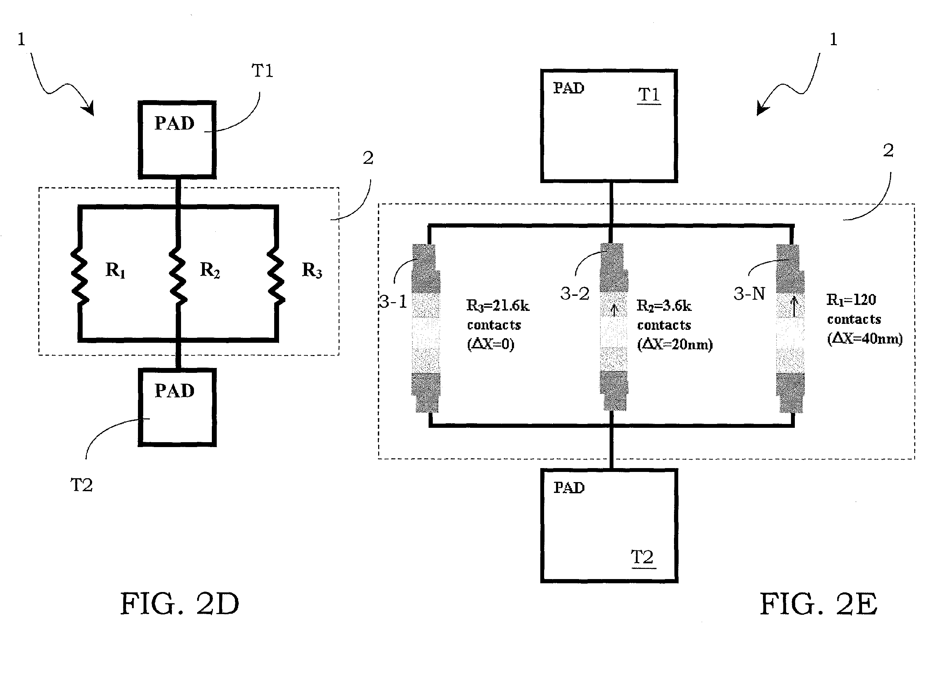

A testing structure 1 is thus obtained, which has the configuration shown in figures 2D and 2E. Particularly, the architecture 2 comprises three resistors (as impedances 3-1, ..., 3N), R1, R2, R3 connected, in parallel with each other, between the terminals T1 and T2.

In the case being examined, resistors are current "sinks", i.e. they are in the DC bias state.

Resistors R1, R2 and R3 have growing resistance values, in order to satisfy the relation (1), for example:

R1 = R
R2 = 10 R
R3 = 100 R

In this case, the resistance R1 is associated with the most critical configuration (lowest $\Delta X$), R2 to the averagely critical configuration and R3 to the less critical configuration (highest $\Delta X$).

The total resistance RTOT of the architecture 2 satisfies the relation (2), i.e.:

$$1/RTOT = 1/R1 + 1/R2 + 1/R3 = 1/R + 1/10R + 1/100R = 111/100 \ R$$

It thus results that the total resistance RTOT is given by:

$$RTOT = 100/111 \ R = RA$$

Considering the case wherein the most critical configuration, associated with R1, fails, it results that:

$$1/RTOT = 1/R2 + 1/R3 = 1/10R + 1/100R = 11/100 \ R$$

$$i.e. \ RTOT = 100/ \ 11 \ R = RB$$

In substance, the resistance measure of the architecture 2 provides a value RB being about 10 times higher than the value RA corresponding to the correct operation of all the configurations.

Considering the case wherein the averagely critical configuration, associated with R1, also fails, it results that:

$$1/RTOT = 1/R3 = 1/100R$$

$$i.e. \ RTOT = 100 \ R = RC$$

In substance, the resistance measure of the architecture 2 provides a value RC being about 10 times higher than the value RB indicating the test failure by the most critical configuration and about 100 times higher than the value RA corresponding to the correct operation of all the configurations.

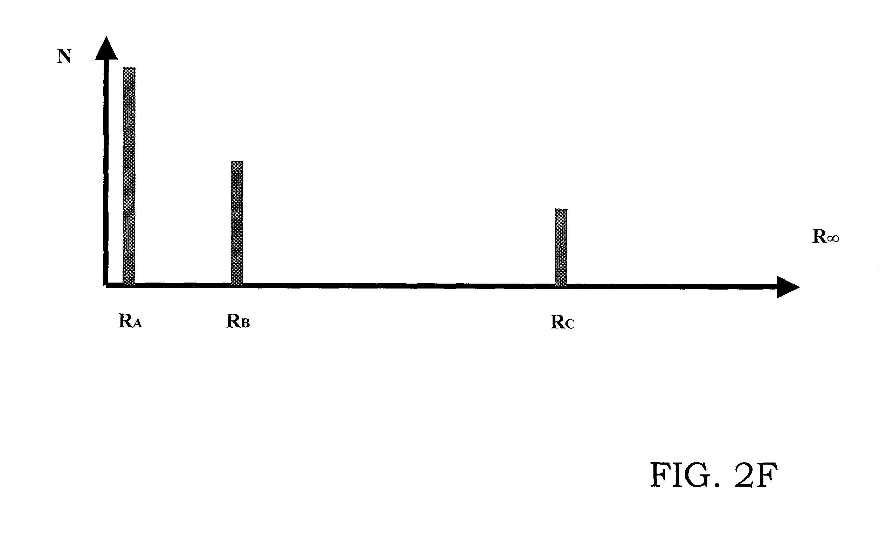

In substance, the testing structure 1 according to the invention allows a four-mode histogram to be obtained: correct operation, most critical configuration failure, most and averagely critical configuration failure, total failure, as shown in figure 2F.

It should be remembered that by using the testing method according to the invention, it is possible to estimate the criticality of the misalignment $\Delta X$ of the LIL and poly masks by measuring a total resistance value of the architecture 2 of a testing structure 1 realised according to the invention by means of a plurality of parallel resistors.

In a practical case, considering misalignment values $\Delta X$ being respectively equal to 0, 20nm and 40nm, a testing structure 1 as shown in figure 2E is obtained.

In this case, the resistance values of the architecture 2 are as follows:

R1 = 120 contacts
R2 = 3.6 kcontacts
R3 = 21.6 kcontacts

Particularly, given a single contact resistance value being equal to about 10$\Omega$, the total resistance value RA, without failures of the configurations being tested (and considering in first approximation a single contact resistance being constant for all the configurations) is equal to about 1k$\Omega$.

In this case, if the configuration with $\Delta X$=40nm fails, a total resistance value RB being equal to about 30k$\Omega$ is obtained. If the configuration with $\Delta X$=20nm fails, a total resistance value RB being equal to about 200k$\Omega$ is obtained.

It should be noted that in the approximations being considered the resistance values are slightly underestimated with respect to a real case.

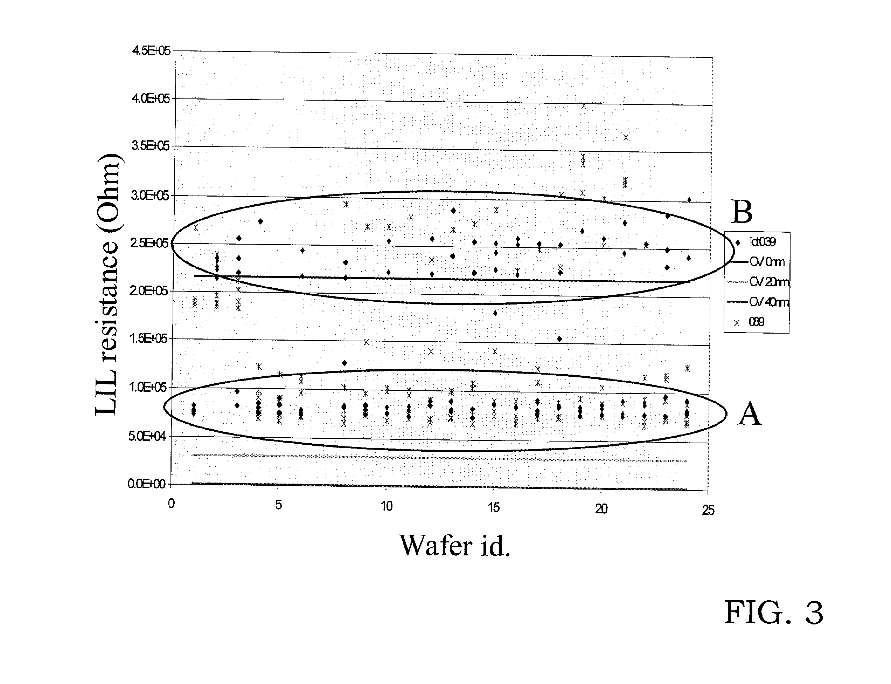

Figure 3 shows, in the form of a diagram, the experimental results of tests carried out by the Applicant itself on two batches of integrated circuit wafers of the type with 5 pins on each wafer, with 24 wafers in each batch.

A double-peak distribution can be clearly seen in the figure. Particularly, it happens that the misalignment $\Delta X$=40nm always fails (area A) and the double-peak distribution indicates the configurations for which only the misalignment $\Delta X$=40nm fails (area A) and the configurations for which both the misalignment $\Delta X$=40nm and the misalignment $\Delta X$=20nm fail (area B).

According to another embodiment of the structure 1 and of the testing method according to the invention, considering again a FLASH memory manufacturing process, the criticality of the contact-gate distance of memory cells is known in the specific technical field.

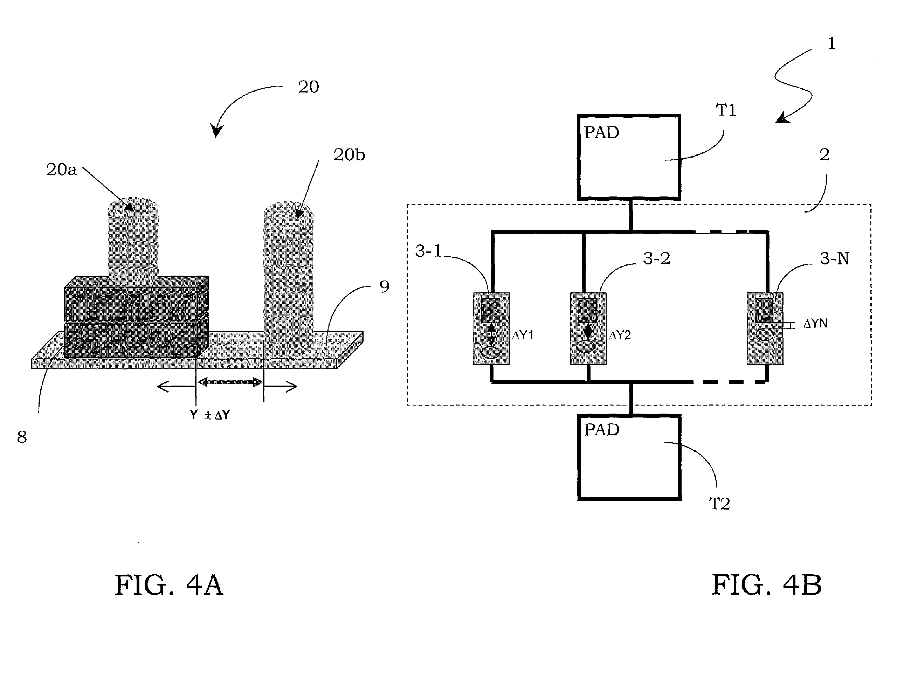

Referring to figures 4A and 4B, a testing structure 1 comprising three contact-cell configurations corresponding to different contact-gate distance values is shown.

Figure 4A shows an impedance element 20 associated with a gate terminal 8 and with a contact terminal 9 located at a distance Y, variable by $\pm\Delta Y$. Particularly, the impedance element 20 comprises a first 20a and second impedance 20b associated with the gate terminal 8 and contact terminal 9 respectively.

Advantageously according to the invention, the impedance element 20 has a resistive value depending on the distance change $\pm\Delta Y$ between the gate 8 and contact terminal 9.

A testing structure 1 as shown in figure 4B is thus obtained. Particularly, the architecture 2 comprises a plurality of impedance elements 3-1, 3-2, ..., 3-N with resistive values R1, R2, ..., R3, connected, in parallel with each other, between the terminals T1 and T2.

Also in that case, the architecture 2 has a total resistance value RTOT satisfying the relation:

$$1/RTOT = 1/R1 + 1/R2 + ... + 1/RN$$

In case of a short circuit between a contact terminal and a gate terminal in any of the configurations 3-1, 3-2, ..., 3-N, a sudden decrease in the total resistance RTOT of the architecture 2 occurs, indicating this malfunction.

It is also possible to increase the sensitivity of the testing structure 1 shown in figure 4B by using a non-silicide active area, i.e. realised by means of a process not providing a salicide process step.

In conclusion, the testing structure 1 according to the invention allows "multilevel" responses to be provided in correspondence with respective contact terminals provided in the structure by using a plurality of impedance elements connected with different embodiments of a device to be tested, having different parameters and thus a different criticality.

The testing structure 1 according to the invention allows batches of devices to be tested, which have different configurations associated with a plurality of values of a critical parameter, and the highest criticality of the device configuration to be calculated, being capable of overcoming a testing step on the basis of the impedance value ZTOT obtained for the testing structure 1.

**Claims**

1. A testing structure (1) for an electronic device of the type comprising a first and a second terminal (T1, T2) being effective for providing impedance values of said testing structure (1), as well as an architecture (2) of distributed impedance elements (3-1, 3-2, ..., 3-N) associated with a plurality of configurations of said device to be tested having different criticality levels and connected, in parallel with each other, between said first and second terminal (T1, T2).

2. A testing structure (1) according to claim 1, **characterised in that** said plurality of impedance elements (3-1, 3-2, ..., 3-N) have different impedance values (1/Z1, 1/Z2, ..., 1/ZN), said configurations of said device to be tested with growing criticality being associated with impedance elements (3-1, 3-2, ..., 3-N) having growing impedance values.

3. A testing structure (1) according to claim 2, **characterised in that** said different impedance values (1/Z1, 1/Z2, ..., 1/ZN) satisfy the following relation:

$$|Z1|<|Z2|<...<|ZN|$$

ZN being a less critical impedance value associated with a lowest criticality level.

4. A testing structure (1) according to claim 1, **characterised in that** said impedance elements (3-1, 3-2, ..., 3-N) are resistors.

5. A testing structure (1) according to claim 1, **characterised in that** said configurations of said device to be tested respectively comprise a first (5) and second mask (6) being located at a variable distance ($X\pm\Delta X$), said variable distance being said criticality level of said configurations, said impedance elements (3-1, ..., 3-N) comprising respective resistances being located in such a way to contact said first and second masks (5, 6) of said configurations.

6. A testing structure (1) according to claim 1, **characterised in that** said configurations of said device to be tested respectively comprise a first (8) and a second contact (9) located at a variable distance ($Y\pm\Delta Y$), said variable distance being said criticality level of said configurations, said impedance elements (3-1, ..., 3-N) comprising respective first and second resistances (20a, 20b) located in such a way to contact said first and second contact (8, 9) of said configurations.

7. A testing structure (1) according to claim 6, **characterised in that** it comprises at least a non-silicide contact.

8. A testing structure (1) according to claim 1, **characterised in that** said plurality of impedance elements (3-1, 3-2, ..., 3-N) of said architecture (2) provide a plurality of response levels of said testing structure (1).

9. A testing structure (1) according to claim 1, **characterised in that** said first and second terminals (T1, T2) are realised by means of mini contact pads being integrated on board of said device to be tested.

10. A testing method for an electronic device of the type comprising the steps of:

   - providing a testing structure (1) comprising a first and second terminal (T1, T2) connected by means of an architecture (2) of distributed impedance elements;

   - providing a plurality of configurations of said device to be tested having a different criticality;

   - associating said plurality of configurations of said device to be tested with a plurality of impedance elements (3-1, 3-2, ..., 3-N) of said architecture (2) connected, in parallel with each other, to said first and second terminal (T1, T2);

- subjecting said configurations of said device to be tested to a testing step;

- measuring an impedance value (ZTOT) of said architecture (2) in correspondence with said first and second terminal (T1, T2); and

- calculating a highest criticality level of a configuration of said device to be tested being capable of overcoming said testing step on the basis of said measured impedance value (ZTOT).

11. A testing method according to claim 10, **characterised in that** it provides different impedance values (1/Z1, 1/Z2, ..., 1/ZN) for said plurality of impedance elements (3-1, 3-2, ..., 3-N), said configurations of said device to be tested with growing criticality being associated with impedance elements (3-1, 3-2, ..., 3-N) having growing impedance values.

12. A testing method according to claim 11, **characterised in that** said different impedance values (1/Z1, 1/Z2, ..., 1/ZN) satisfy the following relation:

$$|Z1|<|Z2|<...<|ZN|$$

ZN being a less critical impedance value associated with a lowest criticality level.

13. A testing method according to claim 11, **characterised in that** it provides a plurality of response levels in correspondence with said plurality of impedance elements.

14. A testing method according to claim 10, **characterised in that** said step of calculating a highest criticality level of a configuration of said device to be tested being capable of overcoming said testing step uses the following relation:

$$1/ZTOT = 1/Z1 + 1/Z2 + ... + 1/ZN$$

and, being M a number of configurations of said device to be tested not overcoming said testing step starting from a more critical configuration, it checks if said total impedance value (ZTOT) satisfies the following relation:

$$1/ZTOT = 1/ZM + 1 + ... + 1/ZN$$

EP 1 587 144 A1

1

T1

PAD

2

$1/Z_1$  $1/Z_2$  $1/Z_N$

3-1  3-2  3-N

PAD

T2

FIG. 1

FIG. 2A

3

FIG. 2C

6

contact

Field Oxide

3

5

FIG. 2B

FIG. 2D

FIG. 2E

N

R$_A$    R$_B$                    R$_C$

R$\infty$

FIG. 2F

FIG. 3

EP 1 587 144 A1

FIG. 4B

FIG. 4A

**European Patent Office**

## EUROPEAN SEARCH REPORT

Application Number

EP 04 42 5268

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 861 679 A (NAGANO TAKASHI) 19 January 1999 (1999-01-19) * abstract * | 1,4,5,8, 10,13,14 | H01L23/544 G03F7/20 |
| Y | * column 2, line 35 - line 60 * * column 5, line 29 - column 6, line 28 * * figures 5,6 * | 11,12 | |
| A | | 2,3,6,7, 9 | |
| | ----- | | |
| X | US 6 312 964 B1 (MOYAL NATHAN Y) 6 November 2001 (2001-11-06) * abstract * | 1-4,8 | |
| Y | * column 1, line 29 - line 34 * * column 2, line 28 - column 3, line 21 * * column 4, line 36 - column 5, line 67 * * figure 1 * | 11,12 | |
| A | | 5,6,10, 13,14 | |
| | ----- | | TECHNICAL FIELDS SEARCHED (Int.Cl.7) |
| X | US 5 485 095 A (BERTSCH JOHN E ET AL) 16 January 1996 (1996-01-16) * abstract * * column 4, line 22 - column 5, line 42 * * figure 1 * | 1,4,8 | G01R H01L G03F |
| A | | 2,3,10 | |
| | ----- | | |
| A | PATENT ABSTRACTS OF JAPAN vol. 1997, no. 11, 28 November 1997 (1997-11-28) & JP 9 200093 A (MITSUBISHI ELECTRIC CORP), 31 July 1997 (1997-07-31) * abstract * | 1,4,8, 10,14 | |
| | ----- | | |

The present search report has been drawn up for all claims

| Place of search | Date of completion of the search | Examiner |
|---|---|---|
| Berlin | 12 October 2004 | Morena, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 587 144 A1**

## ANNEX TO THE EUROPEAN SEARCH REPORT
## ON EUROPEAN PATENT APPLICATION NO.

EP 04 42 5268

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2004

| Patent document cited in search report | | Publication date | Patent family member(s) | | Publication date |
|---|---|---|---|---|---|
| US 5861679 | A | 19-01-1999 | JP | 3552077 B2 | 11-08-2004 |
| | | | JP | 10050703 A | 20-02-1998 |
| US 6312964 | B1 | 06-11-2001 | US | 6111269 A | 29-08-2000 |
| US 5485095 | A | 16-01-1996 | NONE | | |
| JP 9200093 | A | 31-07-1997 | NONE | | |

EPO FORM P0459

For more details about this annex : see Official Journal of the European Patent Office, No. 12/82

16